Europäisches Patentamt

European Patent Office

Office européen des brevets

(11) Veröffentlichungsnummer: **0 280 125 B1**

(12) **EUROPÄISCHE PATENTSCHRIFT**

(45) Veröffentlichungstag der Patentschrift: **25.11.92**

(21) Anmeldenummer: **88102047.3**

(22) Anmeldetag: **12.02.88**

(51) Int. Cl.$^5$: **H03K 4/62**

(54) **Zeilenablenkschaltung für verschiedene Zeilenfrequenzen.**

(30) Priorität: **21.02.87 DE 3705615**

(43) Veröffentlichungstag der Anmeldung:
**31.08.88 Patentblatt 88/35**

(45) Bekanntmachung des Hinweises auf die
Patenterteilung:
**25.11.92 Patentblatt 92/48**

(84) Benannte Vertragsstaaten:
**AT BE CH DE ES FR GB GR IT LI LU NL SE**

(56) Entgegenhaltungen:
**EP-A- 0 178 900**
**US-A- 4 129 807**
**US-A- 4 153 862**

(73) Patentinhaber: **Deutsche Thomson-Brandt GmbH**
**Hermann-Schwer-Strasse 3 Postfach 1307**
**W-7730 Villingen-Schwenningen(DE)**

(72) Erfinder: **Rilly, Gerard, Dr. Ing.**
**Panoramaweg 8**
**W-7731 Unterkirnach(DE)**

## Beschreibung

Bei Monitoren für Datenverarbeitungsanlagen und auch bei Fernsehempfängern für Mehrnormenbetrieb besteht oftmals die Aufgabe, wahlweise Signale mit unterschiedlicher Zeilenfrequenz darzustellen. Das ist z.B. bei einem Monitor in der Informatik der Fall, wenn mit dem Monitor wahlweise Signale verschiedener Signalgeber dargestellt werden sollen, die eine unterschiedliche Zeilenfrequenz aufweisen. Die Zeilenablenkschaltung des Monitors oder des Fernsehempfängers muß dann auf verschiedene Zeilenfrequenzen umgeschaltet oder an diese angepaßt werden.

Bei der Zeilenablenkschaltung ist während der Hinlaufzeit an eine Induktivität eine konstante Betriebsspannung angelegt, so daß der Strom in der Induktivität etwa linear ansteigt. Der Wert des Stromes am Ende der Hinlaufzeit, der die Bildbreite bestimmt, ist dabei unter anderem abhängig von dem Wert der Induktivität, der Dauer der Hinlaufzeit und der Höhe der angelegten Betriebsspannung. Bei höheren Zeilenfrequenzen und somit kürzerer Hinlaufzeit muß zur Einhaltung der Bildbreite daher der Ablenkstrom in einer kürzeren Zeit den vorgegebenen Wert erreichen. Da der Wert der Induktivität unverändert bleibt, muß die angelegte Betriebsspannung entsprechend erhöht werden. Diese Forderung besteht auch deshalb, weil die aus dem Zeilenrücklaufimpuls gewonnene Hochspannung ebenfalls bei den einzelnen Normen konstant bleiben muß.

Es ist bekannt, bei den verschiedenen Zeilenfrequenzen unterschiedlich hohe Betriebsspannungen an die Zeilenablenkschaltung anzulegen. Diese Lösung hat schaltungstechnische Nachteile, zumal dazu die in der Regel stabilisierte Betriebsspannung umgeschaltet werden muß.

Es ist auch bekannt, die Betriebsspannung bei den verschiedenen Zeilenfrequenzen an verschiedene Abgriffe der Primärwicklung der Zeilenendstufe anzuschalten. Diese Lösung erfordert jedoch zusätzliche Abgriffe der Primärwicklung und ist in der Praxis nur für zwei verschiedene Frequenzen anwendbar, die sich nur um etwa 20 % voneinander unterscheiden.

Es ist auch bekannt, die Betriebsspannung der Primärwicklung des Zeilentransformators über einen elektronisch steuerbaren Schalter in Form eines Schalttransistor zuzuführen und den Schalter in Abhängigkeit von der Zeilenfrequenz zu einem Zeitpunkt während der Hinlaufzeit einzuschalten, der um einen definierten Betrag vor dem Beginn des Rücklaufs liegt. Bei hoher Zeilenfrequenz und somit hoher benötigter Betriebsspannung wird der Schalter früher und bei niedriger Zeilenfrequenz später eingeschaltet. Bei minimaler Zeilenfrequenz ist der Schalter nur während eines minimalen Teils der Zeilenhinlaufzeit geschlossen und bei maximaler Zeilenfrequenz praktisch immer durchlässig. Auf diese Weise wird der Mittelwert der an die Zeilenendstufe angelegten Betriebsspannung geändert und der jeweiligen Zeilenfrequenz angepaßt.

Die zuletzt beschriebene Lösung erfordert für den elektronischen Schalter einen Schaltimpuls, dessen Einschaltflanke um einen definierten und regelbaren Betrag vor der Vorderflanke des Rücklaufimpulses liegt. Dieser Betrag erstreckt sich fast über die ganze Zeilenhinlaufzeit. Bei einer periodischen Spannung kann ein solcher Schaltimpuls um einen definierten Betrag vor der Vorderflanke eines Impulses jeweils aus dem vorangehenden Impuls durch Impulsformer oder Verzögerungsstufen abgeleitet werden. Diese Lösung ist im vorliegenden Fall aber nur bedingt anwendbar, weil wegen der unterschiedlichen Frequenzen der zeitliche Abstand zwischen zwei Rücklaufimpulsen nicht konstant ist, sondern von der jeweiligen Zeilenfrequenz abhängt.

Der Erfindung liegt die Aufgabe zugrunde, eine einfache Schaltung zu schaffen, mit der ein Schaltimpuls mit definierter und regelbarer Phasenlage relativ zum folgenden Zeilenrücklaufimpuls erzeugt werden kann.

Diese Aufgabe wird durch die im Anspruch 1 beschriebene Erfindung gelöst. Vorteilhafte Weiterbildung der Erfindung sind in den abhängigen Ansprüchen beschrieben.

Die Erfindung beruht auf der folgenden Wirkungsweise: Die zeilenfrequente Impulsspannung, deren in Richtung gesperrten Transistors gerichtete Flanke dem Beginn des Rücklaufs entspricht, wird über einen zur Wechselstromkopplung dienenden Kondensator und ein zur Integration dienendes RC-Glied an die Basis des Transistors angelegt. Der Basis wird andererseits der Steuerstrom zugeführt. Solange der Steuerstrom null ist, kann durch die Wirkung des genannten Kondensators kein Basisstrom in den Transistor hineinfließen. Der Transistor bleibt daher gesperrt. Das integrierte, sägezahnförmige Signal an dem Kondensator des Siebgliedes wird dabei an der Basis/Emitter-Strecke des Transistors geklemmt, ohne daß dadurch der Transistor leitend wird. Der über den Widerstand des Siebgliedes fließende Strom bewirkt dabei die Umladung des Kondensators des RC-Gliedes in dem Sinne, daß an dem Kondensator eine sägezahnförmige Spannung entsteht. Erst die Summe aus dem Strom über den Widerstand und den Steuerstrom ist in der Lage, einen Basisstrom am Transistor zur erzeugen und dadurch den Transistor leitend zu steuern. Der Stromfluß des Transistors setzt ein, wenn die Spannung an der Basis um mehr als 0,6 V positiver ist als die Spannung am Emitter. Der Widerstand im Kollektorkreis des Transistors ist dabei so hochohmig bemessen, daß der Transistor als reiner Schalter arbeitet. Bereits bei einem sehr geringen Basisstrom gelangt der Transistor in die Sättigung, wird also voll leitend. Die dadurch am Kollektor entstehende Rechteckspannung mit Werten zwischen null bei leitendem Transistor und Betriebsspannung bei gesperrten Transistor ist dabei in der Impulsweite entsprechend dem Steuerstrom moduliert. Bei steigendem Steuerstrom wird die Impulsdauer, d.h. die Dauer des Anteils des Impulses mit null bei leitenden Transistor entsprechend größer. Die Schaltung arbeitet im Sinne eine PWM, nämlich einer Pulsweitenmodulation, wobei die Impulsweite eine Funktion des Steuerstromes ist. Besonders vorteilhaft dabei ist, daß die Schaltung in der beschriebenen Weise unabhängig von der Frequenz der jeweils zugeführten Steuerspannung, also der Zeilenfrequenz arbeitet.

Die zeitliche Lage der Impulsflanke beim Stromeinsatz des Transistors vor dem Beginn des Rücklaufimpulses ist also von dem Wert des Steuerstrom abhängig. Diese zeitliche Lage bestimmt wiederum die Einschaltdauer der Betriebsspannung für die Zeilenendstufe und damit den Maximalwert des Ablenkstromes, die Bildbreite und die Hochspannung. Wenn somit der Steuerstrom aus dem jeweiligen Maximalwert des Ablenkstromes oder der Amplitude der am Endstufentransistors auftretenden Rücklaufspannung gewonnen wird, kann der Steuerstrom durch Veränderung des Zeitpunktes des Einschaltens des im Weg der Betriebsspannung liegenden Transistors zur Regelung der Amplitude des Ablenkstromes und damit der Bildbreite jeweils auf den Sollwert ausgenutzt werden. Es ergibt sich somit mit einfachen Schaltungsmitteln eine einfache Schaltung, die selbsttätig bei den unterschiedlichen Zeilenfrequenzen den Zeitpunkt der Anschaltung der Betriebsspannung an die Zeilenendstufe so regelt, daß unabhängig von der Zeilenfrequenz der Maximalwert des Ablenkstromes, die Bildbreite und die aus dem Zeilenrücklaufimpuls erzeugte Hochspannung konstant bleiben.

Die Erfindung wird in folgenden anhand der Zeichnung an einem Ausführungsbeispiel erläutert. Darin zeigen

Fig. 1 die grundsätzliche Wirkungsweise der Zeilenablenkschaltung mit geschaltet Betriebsspannung,

Fig. 2 Kurven zur Erläuterung der Wirkungsweise der Schaltung nach Fig. 1,

Fig. 3 im Prinzip die erfindungsgemäße Schaltung,

Fig. 4 Kurven zur Erläuterung der Schaltung nach Fig. 3,

Fig. 5 eine Übersicht über das Zusammenwirken der einzelnen Stufen,

Fig. 6 ein detailliertes Schaltbild der Schaltung nach Fig. 5 und

Fig. 7 Kurven zur Erläuterung der Wirkungsweise der Schaltung nach Fig. 6.

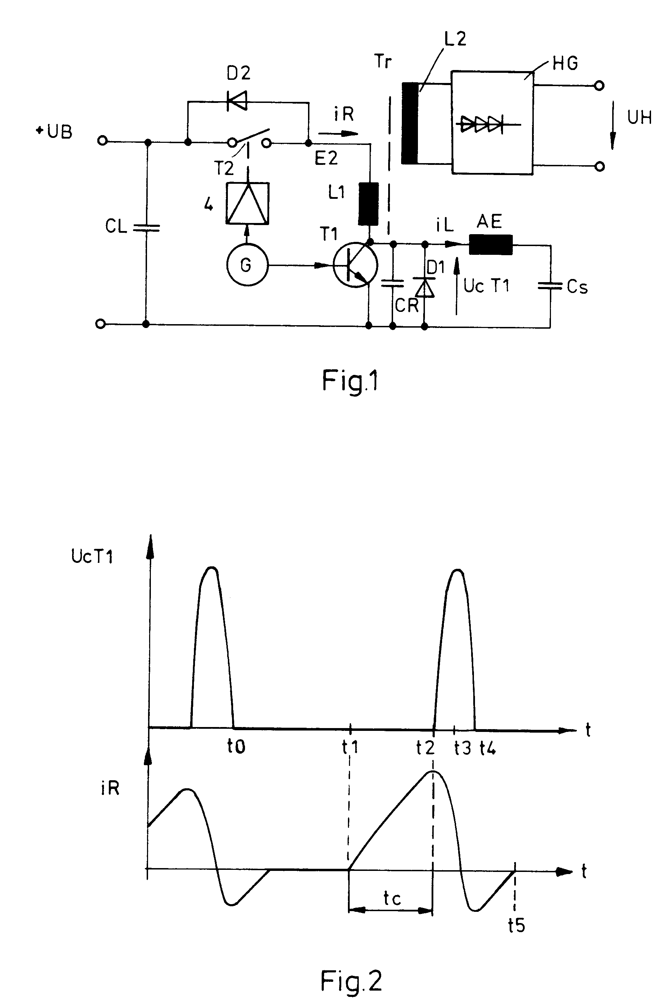

Fig. 1 zeigt eine Zeilenablenkschaltung mit der Betriebsspannung UB, der Primärwicklung L1 und der Hochspannungswicklung L2 des Zeilentransformators Tr, dem Zeilenendstufentransistor T1, dem Rücklaufkondensator CR, der Rücklaufdiode D1, der Zeilenablenkspule AE, dem Koppelkondensator Cs und dem Hochspannungsgleichrichter HG zur Erzeugung der Hochspannung UH. Die an dem Siebkondensator CL stehende konstante Betriebsspannung UB ist über den elektronischen Schalter T2 an die Wicklung L1 angelegt. Der Zeilenoszillator G steuert einerseits den Transistor T1 und andererseits über den Modulator 4 den Schalter T2.

Fig. 2 zeigt die am Kollektor des Transistors T1 auftretende Spannung UcT1 mit der Hinlaufzeit von t0 - t2 und der Rücklaufzeit von t2 - t4. Der Schalter T2 ist jeweils während der Rücklaufzeit leitend und während eines von der jeweiligen Frequenz abhängigen Teiles der Hinlaufzeit gesperrt. Gemäß Fig. 2 wird der Schalter T2 von dem Modulator 4 mit einem Schaltimpuls im Zeitpunkt t1 leitend gesteuert, so daß der Strom iR fließen kann. Der Zeitraum tc zwischen dem Einschaltzeitpunkt t1 und dem Beginn des Rücklaufimpulses im Zeitpunkt t2 bestimmt den Mittelwert der der Endstufe zugeführten Betriebsspannung E2 und ist von der jeweiligen Zeilenfrequenz abhängig. Die Zeit tc von t1 bis t2 muß daher einen definierten, regelbaren Wert haben. Bei minimaler Zeilenfrequenz ist tc minimal, bei maximaler Zeilenfrequenz maximal, und zwar praktisch = t0 bis t2. Die in Fig. 1 dargestellte Diode D2 dient dazu, den negativen Anteil des Stromes iR zu übernehmen.

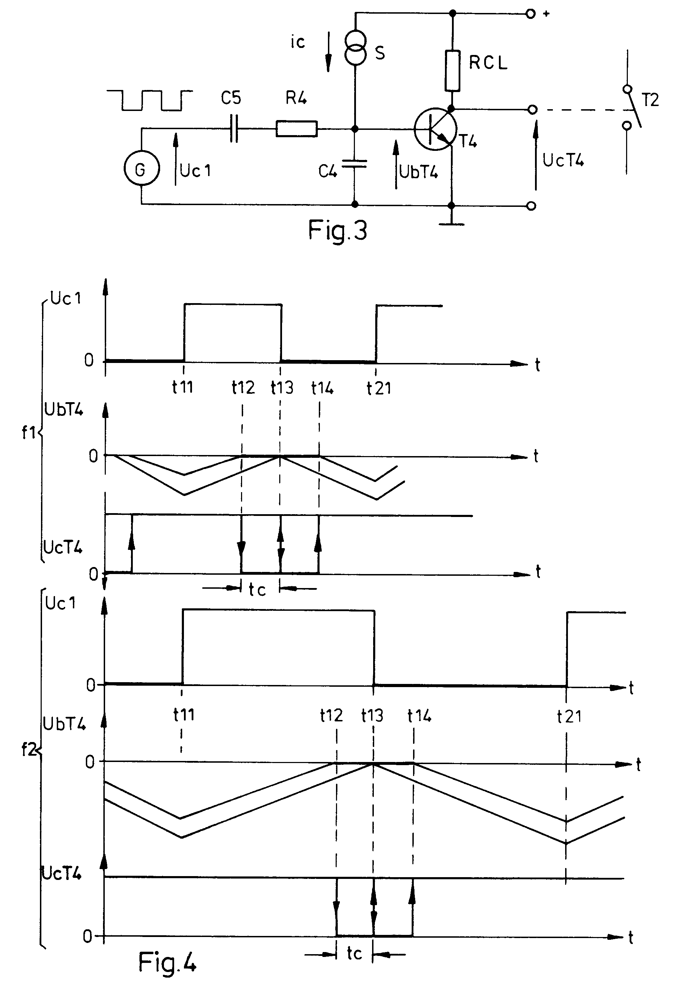

Fig. 3 zeigt die Schaltung zur Erzeugung des Schaltimpulses für den Schalter T2, also die Schaltung des Modulators 4 in Fig. 1. Die zeilenfrequente, rechteckförmige Spannung Uc1, deren negative Flanke mit dem Beginn der Rücklaufzeit zusammenfällt, ist über den zur Wechselspannungskopplung dienenden Kondensator C5 und das Integrierglied mit dem Widerstand R4 und dem Kondensator C4 an die Basis des Transistors T4 angelegt. Der Basis des Transistors T4 wird zusätzlich von der Stromquelle S ein Steuerstrom ic zugeführt. Es sei zunächst angenommen, daß ic = 0 ist. Die Basis/Emitter-Strecke des Transistors T4 bildet eine Diode, so daß die an der Basis stehende, durch Integration von Uc1 gewonnene Spannung UbT4 an der Transistorstrecke geklemmt wird und somit nur negativ oder 0 sein kann (Fig. 4). Der Transistor T4 bleibt dabei durch die Wirkung von C5 gesperrt. Wenn die Stromquelle S einen Steuergleichstrom ic von einigen mA liefert, addiert sich dieser Strom zu dem vom Widerstand R4 gelieferten Strom. Wenn die Zeitkonstante des Integriergliedes R4, C4 genügend groß ist, arbeitet der Transistor t4 als Pulsweitenmodulator (PWM), indem die Dauer des an seinem Kollektor erzeugten Impulses UcT4 von der Größe des Steuerstromes ic abhängig ist.

Wie in Fig. 4 dargestellt, ist die Zeit tc, also die zeitliche Lage der abfallenden Flanke des erzeugten Impulses UcT4 vor dem Beginn der Rücklaufzeit im Zeitpunkt t13, von dem Steuerstrom ic abhängig. Die abfallende Flanke der erzeugten Schaltspannung UcT4 ist somit in der Phase verknüpft mit der negativen Flanke der vom Oszillator G gelieferten Spannung Uc1. Wenn der Steuerstrom ic ansteigt, steigt auch tc an. Wenn ic = 0 ist, ist auch tc = 0. Bei einem geringen Steuerstrom ic ist die Impulsdauer während der leitenden Phase des Transistors T4, nämlich die Zeit von t12 - t14, entsprechend klein. Unabhängig von der Zeilenfrequenz, d.h. der Frequenz von Uc1, erscheint somit der Impuls UcT4 in Abhängigkeit von ic vor der negativen Flanke der Spannung Uc1 und kann daher als Schaltimpuls für den elektronischen Schalter T2 verwendet werden. Der Schaltimpuls erscheint nur dann nicht, wenn ic = 0 ist. Durch einen entsprechend großen Wert von RCL von etwa 10 kohm wird erreicht, daß T4 als reiner Schalter arbeitet. Die Spannung Uc1 kann diejenige Spannung sein, die auch die Treiberstufe der Ablenkschaltung steuert. Die negative, also abfallende Flanke dieser Spannung stimmt mit dem Beginn der Rücklaufzeit überein. In Fig. 4 sind die beschriebenen Verhältnisse für zwei verschiedene Frequenzen f1 und f2 dargestellt. Es ist ersichtlich, daß trotz unterschiedlicher Frequenzen und somit unterschiedlicher Dauer der Hinlaufzeit, die Zeit tc zwischen dem Einschaltzeitpunkt t12 des Transistors T4 und dem Ausschaltzeitpunkt t14 etwa gleich sind. Der Zeitpunkt t12 kann also durch den aus dem Ablenkstrom oder der Rücklaufspannung der Zeilenendstufe abgeleitenden Steuerstrom ic so gesteuert werden, daß unabhängig von der Zeilenfrequenz der Maximalwert des Ablenkstromes, die Bildbreite und die Hochspannung konstant sind.

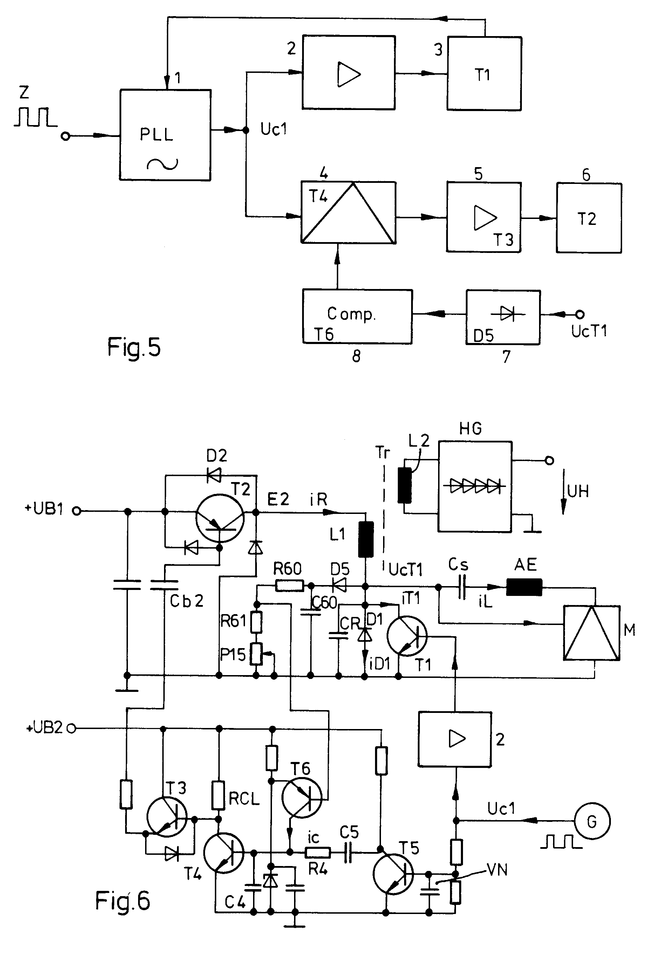

Fig. 5 zeigt das Zusammenwirken der einzelnen Stufen einer Schaltung, die detailliert in Fig. 6 dargestellt ist. Fig. 5 zeigt die PLL- und Oszillatorschaltung 1, an die die aus dem Fernsehsignal abgeleitete zeilenfrequente Spannung Z angelegt ist, die Treiberstufe 2, die Zeilenendstufe 3 mit dem Transistor T1, den Modulator 4 mit dem Transistor T4 von Fig. 3, die dem Modulator 4 in Fig. 1 entspricht, einer Treiberstufe 5 für die Schaltstufe 6 mit dem Transistor T2, einem Spitzengleichrichter 7 für die Spannung UcT1 am Kollektor des Zeilenendstufentransistors T1 und einer Vergleichsstufe 8. Die eingetragenen Symbole deuten an, welche Bauteile in Fig. 6 die einzelnen Stufen in Fig. 5 bilden. Die Stufen 1, 2, 3 in Fig. 5 bilden eine übliche Zeilenablenkschaltung. Die Regelung der Zeilenablenkschaltung für unterschiedliche Zeilenfrequenzen wird durch die Stufe 4 - 8 bewirkt. Die Rücklaufspannung am Kollektor des Zeilenendstufentransistors T1 wird in dem Spitzengleichrichter 7 gleichgerichtet, wodurch eine der Rücklaufamplitude entsprechende Gleichspannung entsteht. Diese Gleichspannung ist auch der erzeugten Hochspannung UH proportional. In der Vergleichsstufe 8 erfolgt ein Vergleich dieser Gleichspannung mit einer internen Vorgabespannung oder Referenzspannung. Aus dem Ergebnis dieses Vergleiches erfolgt die Steuerung der Größe des Steuerstromes ic. Der Steuerstrom ic wirkt in der beschriebenen Weise auf den Modulator 4 mit dem Transistor T4 entsprechend Fig. 3.

Fig. 6 zeigt ein detailliertes Schaltbild der Schaltung nach Fig. 5, wobei gleiche Bezugszeichen für einander entsprechende Bauteile verwendet sind. Die zeilenfrequente Spannung Uc1 von dem Generator G steuert über die Treiberstufe 2 den Endstufentransistor T1. Der Transistor T5 verstärkt die Spannung Uc1, wobei das Verzögerungsnetzwerk VN zur Kompensation der Verzögerung in der Sperrung der Treiberstufe 2 und des Transistors T1 dient. Die Bauteile C5, R4, C4, T4 wirken wie in Fig. 3. Der Transistor T3 dient als Stromverstärker zur direkten Ansteuerung des Transistors T2 über eine kapazitive Kopplung mit dem Kondensator Cb2. Die Diode D5 und der Kondensator C60 erzeugen eine Gleichspannung mit dem Spitzenwert der Spannung UcT1 am Kollektor von T1. Diese Spannung ist mit dem Potentiometer P15 einstellbar und gelangt auf die Basis des Transistors T6. Der Transistor T6 hat die Funktion der Vergleichsstufe 8 gemäß Fig. 5 und erzeugt den von der Größe von UcT1 abhängigen Steuerstrom ic, der in die Basis des Transistors T4 hineinfließt. Durch diese von UcT1 ausgehende beschriebene Regelung des Einschaltzeitpunktes von T2 werden die Ablenkamplitude, die Bildbreite und die Hochspannung konstant gehalten. Wenn UH sinkt, sinkt die Amplitude von UcT1, damit die am Kondensator C60 gewonnene positive Gleichspannung, der Kollektorstrom von T6, nämlich der Wert des Steuerstromes ic steigt an, der Zeitraum tc steigt an, der Wert des Stromes durch T2 steigt an, so daß UcT1 und UH wieder ansteigen und somit auf den gewünschten Wert geregelt werden.

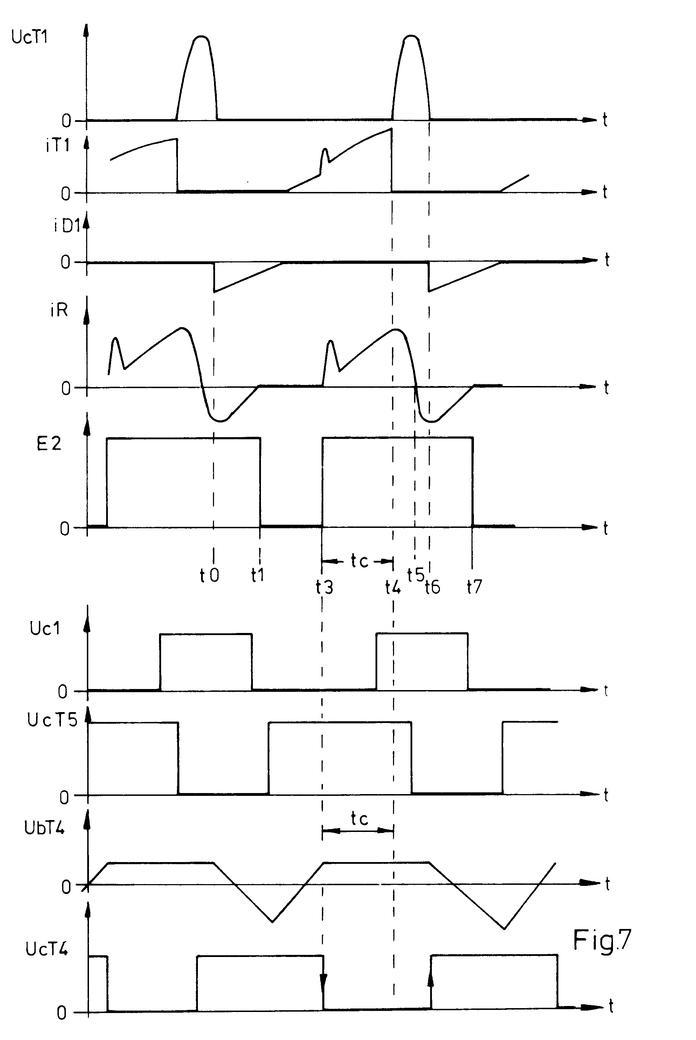

Fig. 7 zeigt die einzelnen Strom- und Spannungsverläufe der Spannungen in der Schaltung nach Fig. 6. UcT1 ist die bereits beschriebene Rücklaufspannung am Kollektor von T1, deren Amplitude auf einen konstanten Wert geregelt wird. iT1 ist der Strom über die Kollektor/Emitter-Strecke von T1, iD1 der Strom durch die Freilauf- oder Rücklaufdiode D1. iR ist der über T2 und D2 in die Wicklung L1 hineinfließende Strom, der von t1 - t3 durch T2 abgeschaltet ist und dessen negativer Anteil über D2 fließt. E2 ist die von t1 - t3 abgeschaltete, an L1 wirksame Betriebsspannung, die durch T2 um die geregelte Zeit tc vor Rücklaufbeginn t5 im Zeitpunkt t3 jeweils eingeschaltet wird. Uc1 ist die beschriebene zeilenfrequente Impulsspannung, die in Fig. 6 als Spannung UcT5 mit der Polarität gemäß Fig. 4 auf den Eingang des Siebgliedes R4, C4 gelangt. UbT4 ist entsprechend Fig. 4 die Spannung an der Basis von T4 und UcT4 die am Kollektor von T4 auftretende und zur Steuerung von T2 dienende Schaltspannung.

**Patentansprüche**

1.  Zeilenablenkschaltung für verschiedene Zeilenfrequenzen, bei der im Weg der Betriebsspannung (UB) zur Zeilenendstufe (T1) ein Schalter (T2) liegt, der durch einen Schaltimpuls (UcT4) jeweils während der Zeilenhinlaufzeit geschlossen wird, dadurch gekennzeichnet, daß der Schaltimpuls (UcT4) vom Kollektor eines Transistors (T4) abgeleitet ist, dessen Basis eine zeilenfrequente Impulsspannung (Uc1) über eine Wechselspannungskopplung (C5) und ein Integrierglied (R4, C4) und ein zur Beeinflussung der Amplitude des Zeilenablenkstroms (iL) dienender Steuerstrom (ic) zugeführt wird.

2.  Schaltung nach Anspruch 1, dadurch gekennzeichnet, daß der Widerstand (RCL) im Kollektorkreis des Transistors (T4) so groß bemessen ist, daß der Transistor (T4) als Schalter arbeitet.

3.  Schaltung nach Anspruch 1, dadurch gekennzeichnet, daß die Impulsflanke der Impulsspannung (Uc1) in Richtung einer Sperrung des Transistors (T4) beim Beginn der Rücklaufzeit der Zeilenablenkschaltung liegt.

4.  Schaltung nach Anspruch 1, dadurch gekennzeichnet, daß der Wert des Steuerstroms (ic) aus einem Vergleich der Amplitude des Zeilenablenkstroms (iL) oder der Rücklaufspannung (UcT1) mit einem Vorgabewert gewonnen ist.

5.  Schaltung nach Anspruch 4, dadurch gekennzeichnet, daß der Kollektor des Endstufentransistors (T1) über einen Gleichrichter (D5) und ein Potentiometer (P15) an die Basis eines Transistors (T6) angeschlossen ist, dessen den Steuerstrom (ic) liefernde Kollektor-Emitter-Strecke zwischen einer Betriebsspannung und der Basis des den Schaltimpuls (UcT4) liefernden Transistors (T4) liegt.

**Claims**

1.  Line deflection circuit for different line frequencies in which, in the path of the operating voltage (UB) for the line output stage (T1), there is located a switch (T2) which is closed during each forward sweep period by a switching pulse (UcT4), characterized in that, the switching pulse (UcT4) is derived from the collector of a transistor (T4) to whose base there is supplied a line frequency pulse voltage (Uc1) via an alternating voltage coupling (C5) and an integrating element (R4, C4) and a control current (ic) serving for the influencing of the amplitude of the line deflection current (iL).

2.  Circuit in accordance with claim 1, characterized in that, the resistor (RCL) in the collector circuit of the transistor (T4) is dimensioned such that the transistor (T4) operates as a switch.

3.  Circuit in accordance with claim 1, characterised in that, the pulse edge of the pulse voltage (Uc1) is in a direction effective for the blocking of the transistor (T4) at the start of the fly back period of the line deflection circuit.

4.  Circuit in accordance with claim 1, characterized in that, the value of the control current (ic) is obtained from a comparison of the amplitude of the line deflection current (iL) or the fly back voltage (UcT1) with a predefined value.

5.  Circuit in accordance with claim 4, characterized in that, the collector of the output stage transistor (T1) is connected via a rectifier (D5) and a potentiometer (P15) to the base of a transistor (T6) whose collector - emitter path, which delivers the control current (ic), is located between an operating voltage and the base of the transistor (T4) delivering the switching pulse (UcT4).

**Revendications**

1.  Circuit de balayage des lignes pour différentes fréquences de lignes dans lequel un commutateur (T2) se trouve dans le parcours de la tension de fonctionnement (UB) vers l'étage de fin de ligne (T1), commutateur qui est fermé par une impulsion de commutation (UcT4) respectivement pendant le temps d'aller des lignes, **caractérisé en ce** que l'impulsion de commutation (UcT4) est dérivée par le collecteur d'un transistor (T4) à la base duquel une tension d'impulsion à fréquence ligne (Uc1) est amenée par un couplage de tension alternative (C5) et un circuit d'intégration (R4, C4) et un courant de commande (ic), qui sert à influencer l'amplitude du courant de balayage des lignes (iL) est amené.

2. Circuit selon la revendication 1, **caractérisé en ce** que la résistance (RCL) est dimensionnée dans le circuit du collecteur du transistor (T4) en étant si grande que le transistor (T4) fonctionne comme commutateur.

3. Circuit selon la revendication 1, **caractérisé en ce** que le flanc d'impulsion de la tension d'impulsion (Uc1) se situe en direction d'un blocage du transistor (T4) au début du temps de retour du circuit de balayage des lignes.

4. Circuit selon la revendication 1, **caractérisé en ce** que la valeur du courant de commande (ic) est obtenue par une comparaison de l'amplitude du courant de balayage des lignes (iL) ou de la tension de retour (UcT1) avec une valeur prédéfinie.

5. Circuit selon la revendication 4, **caractérisé en ce** que le collecteur du transistor de l'étage de sortie (T1) est raccordé par un redresseur (D5) et un potentiomètre (P15) à la base d'un transistor (T6) dont le parcours collecteur-émetteur qui livre le courant de commande (ic) se situe entre une tension de fonctionnement et la base du transistor (T4) qui livre l'impulsion de commutation (UcT4).

Fig.1

Fig.2

7

Fig.3

Fig.4

Fig.5

Fig.6

Fig.7